# EUROPEAN PATENT APPLICATION

(11) **EP 1 115 206 A2**
(43) Date of publication of application: **11.07.2001**
(21) Application number: 00311602.7
(22) Date of filing: 21.12.2000
(51) Int. Cl.: H03L 7/099

(54) **Voltage controlled oscillator assembly**

(30) Priority: 22.12.1999 GB 9930411
(71) Applicant: NOKIA MOBILE PHONES LTD., 02150 Espoo (FI)
(72) Inventor: Norskov, Soren, 2200 Copenhagen N (DK); Rasmussen, Carsten, 2100 Copenhagen OE (DK); Hedegaard Povlsen, Neils Thomas, 2800 Lyngby (DK)
(74) Representative: Jones, Kendra Louise

(57) **Abstract**

Voltage controlled oscillator assembly comprising means for detecting a control voltage input and means for generating an output frequency signal depending on said control voltage input. Said voltage controlled oscillator assembly comprises at least two voltage controlled oscillators, means for reading data from an external source, and means for individually switching the at least two voltage controlled oscillators on and off in accordance with the data read.

## Description

The present invention generally relates to a voltage controlled oscillator assembly, and more specifically to a voltage controlled oscillator assembly comprising means for detecting a control voltage input and means for generating an output frequency signal depending on said control voltage input.

Such voltage controlled oscillator assemblies are used in telecommunication for generating various frequencies, such as carrier frequencies for the transmitter in a mobile phone.

There are several different frequency bands allocated for the use in modern mobile communication, i.e. mobile phones and the like. The most commonly used frequency bands are located at approximately 450 MHz, 900 MHz, 1800 MHz, 1900 MHz. But also bands at 2100 MHz and 2500 MHz are of interest.

In order to give the user more freedom, phones that are able cover more than one of these bands have been provided. This obviates the need for several phones, for each of which coverage would have to be checked when trying to communicate.

For a mobile phone to operate it is necessary to be able to generate different frequencies within each of these bands, e.g. for the use as transmitter carrier frequency. This means that it is necessary to provide a local oscillator generating these frequencies, or at least some of these, as lower frequencies may be realised by frequency division of higher frequencies.

The width of these bands, or rather the tuning range needed, is e.g. app. 8% at 900 MHz and 7% at 1800 MHz. However, if both frequencies are to be realised using one oscillator and division, the tuning range needed is 11% and if also 1900 MHz is to be realised a tuning range of 16% is needed.

This means that the local oscillator needs to have quite a high bandwidth in order to be able to generate all the necessary frequencies.

To achieve this bandwidth several methods are known in the art, such as multiple self contained voltage controlled oscillators (VCO's), switched tank circuits and extremely wideband VCO's.

Using multiple self contained VCO's has the disadvantage that it requires a substantial circuitry, viz. a complete set of self contained VCO's for the needed frequency band, each complete with phase locked loop. Further it is necessary to switch between these in order to select one for a specific frequency needed.

Switched tank circuits has the disadvantage of requiring switch components, such as pin diodes to perform the switching. This increases circuit complexity and current consumption. Further the switching components may degrade the performance.

Extremely wideband VCO's are inherently very sensitive to the control voltage, thus making them very sensitive to control voltage noise, which again tightens the overall system noise requirements.

The present invention suggest a circuit comprising a microcontroller controlling two or more VCO's each with its own tank circuit, but incorporated in the same phase locked loop. The centre frequencies of the VCO's are chosen such that their operating intervals overlap.

More specifically the desired bandwidth is achieved using a voltage controlled oscillator assembly according to the opening paragraph wherein the voltage controlled oscillator assembly further comprises at least two voltage controlled oscillators, means for reading data from an external source, and means for individually switching the at least two voltage controlled oscillators on and off in accordance with the data read.

According to an advantageous embodiment of the invention, the means for individually switching the at least two voltage controlled oscillators on and off in accordance with the data read is a microcontroller. Preferably the microcontroller is used for calibrating the selection of the best suited voltage controlled oscillator for a specific frequency among the voltages controlled oscillators in the assembly.

Also, preferably the microcontroller is responsive to control signals controlling a frequency divider in a phase locked loop in which the voltage controlled oscillator assembly is incorporated.

The invention will be explained more fully below, by way of example, in connection with preferred embodiments and with reference to the drawing, in which:
fig. 1 shows an overall block diagram of a frequency source according to the invention,
fig. 2 shows a schematic diagram of the VCO assembly of fig. 1,
fig. 3 shows a schematic diagram of the out of range detector of fig. 2, and
fig. 4 shows overlapping operating intervals for five VCO's.

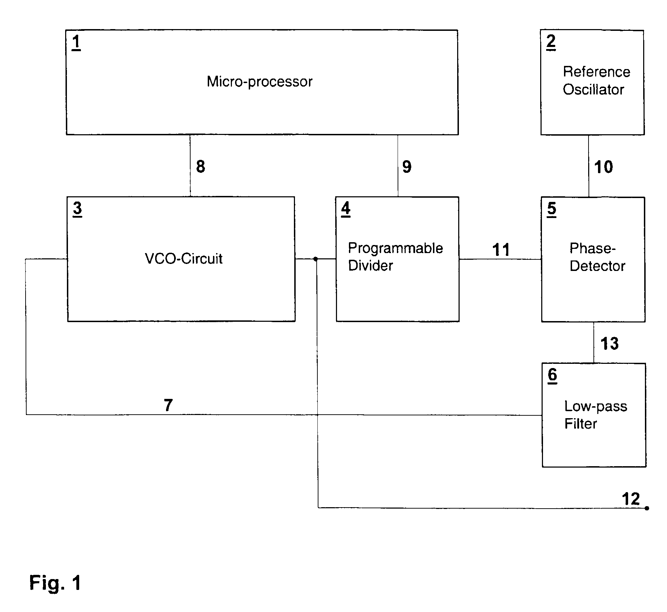

Fig. 1 shows a block diagram of a frequency source according to the invention. The circuit comprises a microprocessor 1, a reference oscillator 2, a phase detector 5, a low pass filter 6, a programmable divider 4 and a VCO assembly 3, all connected in a phase locked loop.

It should be noted, that in the in the following description the word "assembly" is not to be construed in any narrow sense. In particular it is meant to cover not only a unit assembled from discrete elements, but also different circuits manufactured on one and the same chip.

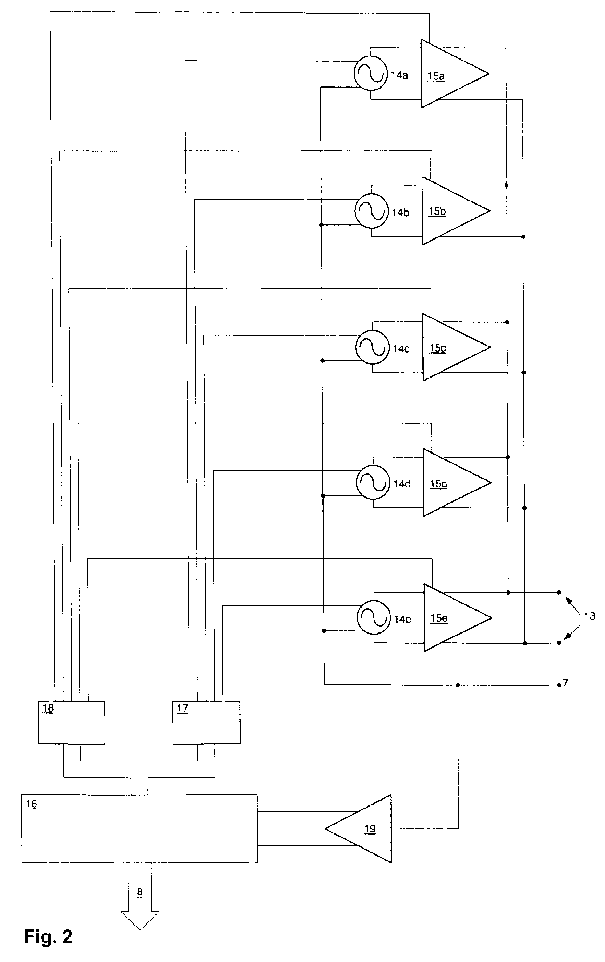

The VCO assembly 3 is shown in greater detail in fig. 2. The VCO assembly 3 comprises a number of VCO's 14a-14e, each having a respective associated buffer amplifier 15a-15e. Connecting the outputs of the VCO's to a bus 13.

Each of the VCO's 14a-14e may be switched on individually by means of a VCO bias circuit 17 controlled by the microcontroller 16, and supplying power to the VCO.

Also, the supply to the buffer amplifiers 15a-15e, may be controlled by the microcontroller 16, via a buffer bias circuit 18.

According to the invention the microcontroller 16 controls the VCO's 14a-14e and their respective buffer amplifiers 15a-15e in such a way that in operation only one of the VCO's is active at a given time, whereas the others are switched off.

This means in fact that they load the output of the active VCO/buffer amplifier, thus limiting the total number of VCO's that may be present in the VCO assembly 3. However, the maximum number of VCO's possible is substantially higher than what will actually be needed for the tuning ranges envisaged.

The five VCO's are tuned to different centre frequencies. The centre frequency being the frequency where the individual VCO has the best performance. On either side the centre frequency the performance of the VCO decreases, eventually to a level where it does not perform well enough for the desired use. This interval is referred to in the following as operating interval or range.

The tuning of the centre frequency for the individual VCO's takes place in the design and manufacturing of the chip on which the VCO assembly 3 is located. In the design the lengths of inductances and areas of capacitor plates are chosen in order to achieve the desired centre frequency. Fine tuning of the centre frequency may be effected by removing some capacitor plate area, e.g. by means of a laser.

The centre frequencies and the operating interval for the VCO's 14a-14e are designed and tuned in such a way that they overlap, thus giving a broad frequency band in which the VCO assembly 3 may operate.

Thus, the VCO assembly 3 may substitute a single wideband VCO in the phase locked loop of fig. 1.

Before further explanation of the invention, a brief description of the operation of the phase locked loop will be given.

The reference oscillator 2, typically a crystal oscillator, generates a fixed frequency signal which is supplied to the phase detector 5 via a line 10. The phase detector 5 compares the phase of the signal on the line 10 with the phase of a frequency signal on the line 11 originating from the VCO assembly 3. This frequency may be divided down by a programmable divider 4 before the phase comparison in the phase detector 5 takes place. Based on the comparison the phase detector 5 generates an error signal on line 13 which, after being filtered by lowpass filter, 6 constitutes a control signal on a line 7.

This signal is in the form of a control voltage signal for a VCO in the VCO assembly 3. Based on the control voltage signal the VCO assembly 3 generates an output signal on the line 12. This signal is at a different frequency than the fixed frequency, depending on the division ratio of the programmable divider 4.

In order to obtain frequencies in the frequency bands indicated earlier, it is desirable to use a total tuning range for the VCO assembly 3 of 3.4-4.0 GHz. The frequencies generated within this tuning range may then conveniently be divided down using integer factors of e.g. 2, 4 or 8, to achieve frequencies in the desired bands of 450 MHz, 900 MHz, 1800 MHz and 1900 MHz. This is done by a divider (not shown) in the output line 12.

As already explained the VCO assembly 3 comprises five voltage controlled oscillators tuned to different centre frequencies, i.e. the frequencies where they perform best. Since this tuning takes place in the design and manufacturing process, they cannot be tuned subsequently in the desired implementation.

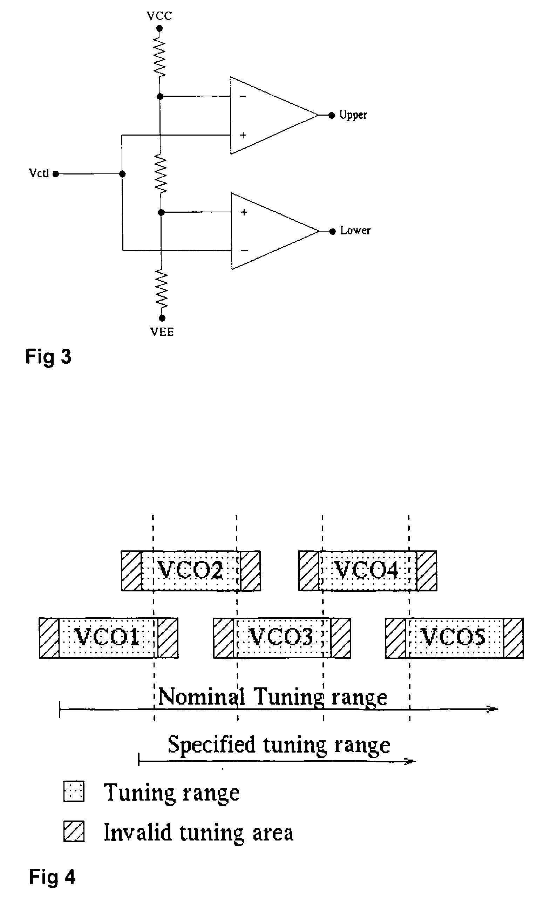

With five individual VCO's 14a-14e there is however an uncertainty as to which one will actually perform best at a given frequency. This is because there are tolerances on both the centre frequency and the operating interval of the individual VCO's. Thus an undetermined overlap exists between adjacent VCO's where they may both operate. This is illustrated in fig. 3.

As mentioned earlier, according to the described embodiment of the invention a microcontroller 16 is provided on the same chip as the VCO's 14a-14e. This microcontroller 16 controls which one of the VCO's is switched on.

This microcontroller 16 may be used in determining which VCO operates best at a given frequency. Thus a calibration of the VCO assembly 3 may be carried out. The calibration is carried out by means of an external microprocessor 1. In the calibration process the performances of the individual VCO's 14a-14e are detected and stored in internal registers in the microcontroller 16 for subsequent use in selecting the most suitable VCO for a given frequency.

In order to allow this calibration, the VCO assembly 3 further comprises an out of range detector 19. In the preferred embodiment the out of range detector 19 is implemented as two level comparators, as shown in fig. 4. The out of range detector 19 detects the control voltage on the line 7. Depending on the value of the control voltage the out of range detector 19 sends either a lower or an upper out of range signal to the microcontroller 16, depending on which limit has been reached. In the presently preferred embodiment using a supply voltage of 2.7 V, limits for acceptable control voltages have been selected to 0.4 V and 2.4 V. For the detected limits the microcontroller 16 stores respective digital values in internal registers.

The calibration process is controlled by the external microprocessor 1. The external microprocessor 1 uses a serial bus 8 to select, via the microcontroller 16, a desired VCO 14a-14e. The operating interval is scanned for a VCO by means of the programmable divider 4.

There are several possible strategies for determining the operating intervals of the VCO's.

Strategy one is a linear scanning upwardly from the lower frequency limit, determining when the individual VCO's get out of their operating interval.

Strategy two is guessing a frequency, getting a verification of the validity thereof by the out of range detector 19, and iteratively trying with higher or lower frequencies until the operating interval is exceeded. This necessitates app. five to six iterations for each limit. At present clock frequencies for the microcontroller 16 and the external microprocessor 1, the calibration takes about 200 microseconds.

When the calibration is done, the microcontroller 16 has information stored in its registers about the operating intervals of each of the VCO's 14a-14e. The microcontroller is thus able to select the appropriate VCO for a given division factor for the programmable divider 4.

Preferably the calibration is carried out each time at power up of the mobile telephone, but in principle it could also be done once and for all for an individual telephone. However, since the performance of the VCO's and other circuitry depends on external conditions, such as operating temperature and (battery) supply voltage, it is currently preferred to do it at power up. In this respect it should be noted though, that saving power is a general object in mobile phones. Thus it may also under certain circumstances, e.g. if faster computing power is available, be preferable to switch the entire frequency source, i.e. the phase locked loop, off between transmission bursts. In that case, the calibration could instead be carried out upon power-up for the phase locked loop.

Regardless of the time and strategy chosen, the calibration takes place in a special calibration mode.

During the calibration the VCO assembly 3 operates in what will subsequently be referred to as a simple control mode, whereas in normal operation the VCO assembly 3 operates in what will be referred to as auto-control mode.

In the simple control modem the external processor 1 instructs the microcontroller 16 as to which one of the individual VCO's is to be switched on. Further the external microprocessor 1 controls the programmable divider 4 via a divider control signal on a line 9.

The divider control signal, or information representing it, is placed on a serial bus 8, where it can be read by the microcontroller 16.

Though in the embodiment shown the divider control signal and the data representing it are placed on two separate lines 9 and 8, respectively, it may just as well be possible to use only one line i.e. having the programmable divider connected to the bus 8, instead of using the separate control line 9.

Regardless of which of the embodiments is preferred, the microcontroller 16 is able to detect the settings for the programmable divider 4 corresponding to the out of range limits detected by the out of range detector 19 during calibration. Thus relations between range limits and the corresponding settings of the programmable divider 4 can be determined and stored in registers associated with the microcontroller 16.

When calibrated the VCO assembly 3 will operate autonomously in auto-control mode, using the calibration data obtained during the calibration process.

In this mode the microprocessor 1 controls the programmable divider 4 to select a division ration corresponding to the desired frequency to be generated.

Like in the simple control mode the divider control signal or information representing it is placed on the bus 8, where it can be read by the microcontroller 16.

Since the microcontroller has information about the VCO's individual performances for specific frequencies, it can automatically select the most appropriate one, for a specific frequency. This can be done autonomously, since the only information it needs may be read from the bus 8.

Thus when calibrated the VCO assembly 3, incorporating the microcontroller 16, VCO's 14a-14e, buffer amplifiers 15a-15e and the out of range detector, can be said to constitute a black box VCO. I.e. independently of fact that it does comprise individual internal VCO's 14a-14e it may in a phase locked loop perform the function of one single wideband VCO.

Despite the fact that in the exemplary embodiment described above, an on chip microcontroller 16 is used, the invention is not limited thereto. Rather, the skilled person will realise that other types of digitally programmable circuits such as microprocessors may be used. Further, even though the envisaged use of this invention is in mobile communications, it is clear that it may find use in any application where a wide range of frequencies are to be generated.

## Claims

1. Voltage controlled oscillator assembly comprising means for detecting a control voltage input and means for generating an output frequency signal depending on said control voltage input, said voltage controlled oscillator assembly further comprises:
• at least two voltage controlled oscillators,
• means for reading data from an external source, and
• means for individually switching the at least two voltage controlled oscillators on and off in accordance with the data read.

2. Voltage controlled oscillator assembly according to claim 1, wherein said means for individually switching the at least two voltage controlled oscillators on and off in accordance with the data read is a microcontroller.

3. Voltage controlled oscillator assembly according to any one of claims 1 or 2, wherein said means for reading data from an external source comprises an input connectable to an external data bus.

4. Voltage controlled oscillator assembly according to claim 1, wherein the outputs of the at least two voltage controlled oscillators are connected in parallel.

5. Method for generating frequencies using a phase locked loop, wherein a microcontroller is used to switch between multiple voltage controlled oscillators arranged in parallel in the same phase locked loop.

6. Method according to claim 5, wherein the microcontroller autonomously switches between the multiple voltage controlled oscillators in accordance with the settings of a programmable divider in said phase locked loop.

7. Method according to claim 6, wherein the microcontroller reads information representing said settings of the programmable divider on a data bus.

8. A variable frequency source comprising at least two voltage controlled oscillators, a fixed frequency generator, a phase detector for generating a control voltage controlling a voltage controlled oscillator among said at least two voltage controlled oscillators, wherein the frequency source further comprises means for selecting among said voltage controlled oscillators.

9. A variable frequency source according to claim 8, and further incorporating a programmable divider situated in the common output line of the voltage controlled oscillators between the voltage controlled oscillators and the phase detector.

10. A variable frequency source according to any one of claims 8 or 9, wherein the means for selecting among said voltage controlled oscillators is a microcontroller arranged on the same chip as said voltage controlled oscillators.

11. Variable frequency source according to any one of claims 8 to 10, wherein the outputs of the at least two voltage controlled oscillators share a common output line.

12. Phase locked loop including a voltage controlled oscillator assembly comprising means for detecting a control voltage input and means for generating an output frequency signal depending on said control voltage input, said voltage controlled oscillator assembly further comprises:
• at least two voltage controlled oscillators,
• means for reading data from an external source, and
• means for individually switching the at least two voltage controlled oscillators on and off in accordance with the data read.

13. Phase locked loop according to claim 12, wherein said means for individually switching the at least two voltage controlled oscillators on and off in accordance with the data read is a microcontroller.

14. Phase locked loop according to any one of claims 12 or 13, wherein said means for reading data from an external source comprises an input connectable to an external data bus.

15. Phase locked loop according to claim 12, wherein the outputs of the at least two voltage controlled oscillators are connected in parallel.

16. Method for calibrating a voltage controlled oscillator assembly according to any one of claims 1-4 and comprising n individual voltage controlled oscillators, said voltage controlled oscillator assembly being incorporated in a variable frequency source according to any one of claims 9-11, characterised in comprising the steps of:
a) selecting an n'th voltage controlled oscillator among the n voltage controlled oscillators,
b) varying the settings of the programmable divider, the selected voltage controlled oscillator thus generating corresponding frequencies,
c) for each of the generated frequencies, determining whether the generated control voltage is within a predetermined valid interval,
d) based on c) storing information about the valid operating interval in relation to the settings of the programmable divider in registers associated with the means for switching the n voltage controlled oscillators,
e) repeating a) to d) for all n voltage oscillators.
